(19)

**Europäisches Patentamt**
**European Patent Office**
**Office européen des brevets**

(11)  **EP 2 752 674 B1**

(12)  **EUROPEAN PATENT SPECIFICATION**

(45) Date of publication and mention
of the grant of the patent:
**26.09.2018  Bulletin 2018/39**

(51) Int Cl.:
*H02H 7/28* *(2006.01)*      *G01R 31/02* *(2006.01)*
*G01R 31/08* *(2006.01)*      *H02H 3/38* *(2006.01)*

(21) Application number: **13150114.0**

(22) Date of filing: **03.01.2013**

(54) **A detection method of a ground fault in an electric power distribution network**

Erkennungsverfahren eines Erdungsfehlers in einem Stromverteilungsnetzwerk

Procédé de détection d'un défaut à la terre dans un réseau de distribution d'énergie électrique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**09.07.2014  Bulletin 2014/28**

(73) Proprietor: **ABB Schweiz AG
5400 Baden (CH)**

(72) Inventors:
• **Farina, Andrea
I-20900 Monza (IT)**

• **Furia, Riccardo
I-20060 Trezzano Rosa (MI) (IT)**

(74) Representative: **De Bortoli, Eros et al
Zanoli & Giavarini S.p.A.
Via Melchiorre Gioia, 64
20125 Milano (IT)**

(56) References cited:
**EP-A1- 1 331 715      EP-A2- 1 195 875
WO-A1-2011/029464      US-A1- 2008 211 511**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to the field of low or medium voltage electric power distribution networks.

In particular, the present invention relates to a detection method of a ground fault in an electric power distribution network.

Another aspect of the present invention regards an electronic protection and control unit for an electric power distribution network.

Further aspects of the present invention relate to a protection and control system for an electric power distribution network and a method for locating a ground fault in an electric power distribution network.

In the past, power distribution networks have generally been designed according to a radial configuration, in which a centralized power generation source is provided to supply downstream passive network branches.

In power distribution networks having a radial structure, the power flow is basically directed according to one direction only, i.e. from the power generation source to the electric loads.

This feature enables to manage the power distribution network in a relatively easy manner, in case a ground fault event occurs.

In fact, since the power flow is basically unidirectional, it is relatively easy to measure the zero sequence current flowing along the phase conductors and detect/locate ground faults on the base of these measurements.

Some examples of existing prior art can be seen in WO 2011/029464 A1, US 2008/211511 A1, EP 1331715 A1, and EP 1195875 A2.

It is well known how, nowadays, distributed power generation systems are developing at an increasingly rapid rate.

This fact implies that current power distribution networks are adopting or may have configurations of the meshed type or configurations in which power generation sources are distributed at different network levels and, more generally, the flow of electric power between different network sections is bidirectional.

It has been observed that traditional methods to detect a ground fault may provide poor performances if they are adopted in power distribution networks having meshed configuration and/or a distributed power generation.

In these power distribution networks, in fact, a zero sequence current flows through all the nodes and feeders of the network, when a ground fault occurs.

The direction of the reactive components of the zero sequence current is quite difficult to be defined because the electrical paths, through which reactive currents circulate, are substantially undetermined.

Therefore, the sole measurements of the phase currents, as it generally occurs in traditional detection methods of a ground fault, do not provide sufficient information to correctly determine the actual direction of the zero sequence current.

Operative situations have been observed in which ground faults cannot be correctly detected and located, thereby leading to non-interventions or wrong interventions of the protection and control system.

In the market, it is therefore quite felt the need of reliable technical solutions enabling to easily detect ground faults in electric power distribution networks having a meshed configuration and/or a distributed power generation.

The main task of the present invention is to provide a detection method of a ground fault in an electric power distribution network that will enable the drawbacks of the known art to be overcome.

In the framework of the above task, a purpose of the present invention is to provide a detection method, which enables a reliable locating of a ground fault even if the electric power distribution network is of the meshed type and/or has a distributed power generation.

A further purpose of the present invention is to provide a detection method that is relatively simple to implement practically, at relatively contained costs.

The above task and purposes, as well as other purposes that will emerge clearly from the ensuing description and from the attached drawings, are provided according to the invention by a detection method of a ground fault in an electric power distribution network, according to the following claim 1 and in the claims depending thereon.

In a further aspect, the present invention provides a method for locating a ground fault in an electric power distribution network, according to the following claims 8 or 9.

In a further aspect, the present invention provides an electronic protection and control unit for an electric power distribution network, according to the following claim 10.

In a further aspect, the present invention provides a protection and control system for an electric power distribution network, according to the following claim 11.

Further characteristics and advantages of the present invention may be more readily appreciated with reference to the ensuing description and to the attached figures, which are provided purely by way of non-limiting illustration and in which:

- Figure 1 is a schematic diagram of a typical electric power distribution network having a meshed configuration;

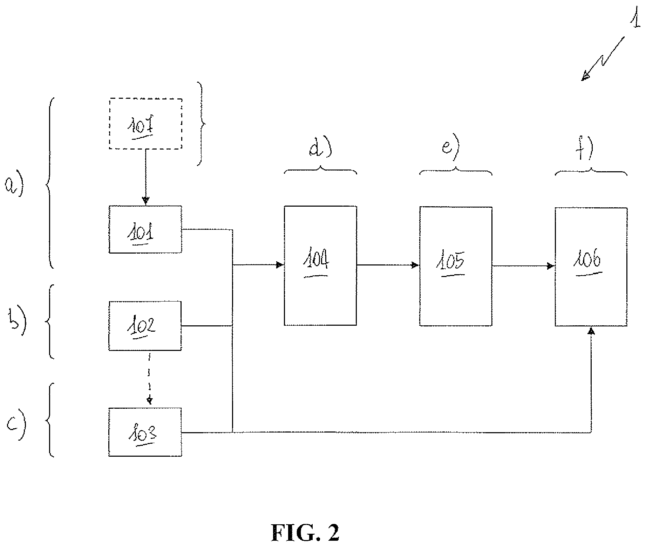

- Figures 2-3 schematically show the steps of the detection method according to the present invention;
- Figures 4A-4B schematically show the steps of method for locating a ground fault, which adopts the detection method according to the present invention;

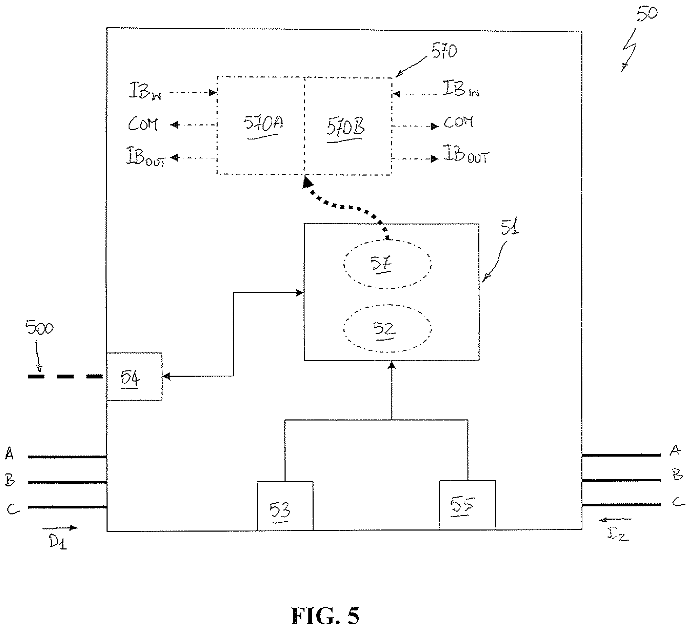

- Figure 5 is a schematic diagram of a protection and control unit capable of executing the detection method according to the present invention;
- Figures 6-8 schematically show examples of the coordinated operation of protection and control units as the one shown in figure 5 in a protection and control system for an electric power distribution network.

With reference to the aforesaid figures, the present invention relates to a detection method 1 of a ground fault in an electric power distribution network 10.

The network 10 is a low or medium voltage electric power distribution network.

Within the framework of the present invention, the term "low voltage" relates to voltages lower than 1 kV AC while the term "medium voltage" relates to voltages lower than 72 kV AC.

Preferably, the network 10 has a meshed configuration and/or a distributed power generation.

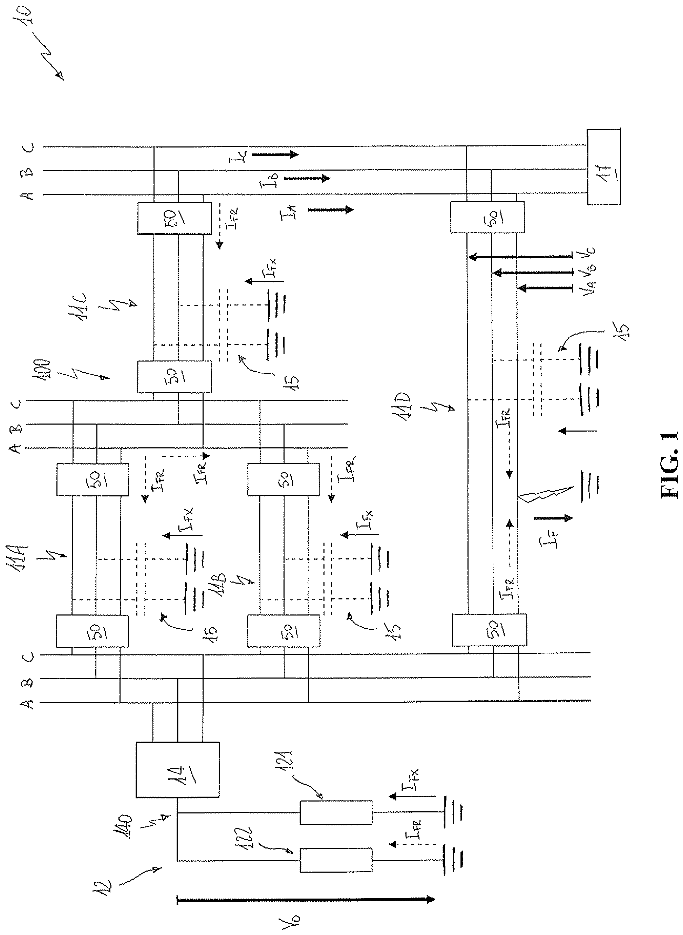

In the example of figure 1, a network 10 with a configuration of the meshed type is shown as an example without the purpose of limiting to the scope of the present invention.

The network 10 is provided with a main power generation source 14 (e.g. a power supply transformer) and it may have one or more distributed additional power generation sources 17.

The network 10 has one or more phase conductors A, B, C.

For the sake of brevity only and without intending to limit the scope of the present invention, the network 10 will be described in the following as having three phase conductors, as shown in figure 1.

As shown in figure 1, the network 10 has electric feeders 11A, 11B, 11C, 11D, each extending between corresponding electric nodes.

The network 10 may be provided with a suitable ground connection circuit 12, which is electrically connected between a radial connection node 140 of the power generation source 14 and the ground.

Preferably, the network 10 is configured so as to have a compensated neutral.

In this case, such a ground connection circuit 12 may comprise a Petersen coil 121 in parallel with a suitably arranged resistive circuit 122.

As an alternative, the ground connection circuit 12 may consist of a resistive circuit only.

In general, when a ground fault occurs at a phase conductor of the network 10 (e.g. at the phase conductor A), a zero sequence current $I_F$ flows through all the feeders and nodes of the network 10, the electric paths formed by the ground coupling capacitances 15 of the phase conductors A, B, C and the ground connection circuit 12 .

The reactive component $I_{FX}$ of the zero sequence current $I_F$ (in figure 1 represented by continuous arrows) flows through the non-faulted phase conductors B, C, the ground coupling capacitances 15 and the ground connection circuit 12 and it may be compensated by the inductance of the coil 121.

In a vector representation of the physical quantities of the network 10, the modulus and direction of vector representing the reactive component $I_{FX}$ of the zero sequence current $I_F$ cannot be determined, since the electric paths formed by the ground coupling capacitances 15 are basically undefined.

The resistive component $I_{FR}$ of the zero sequence current $I_F$ (in figure 1 represented by dotted arrows) flows through the faulted phase conductor A and the ground connection circuit 12 .

The magnitude of the resistive component $I_{FR}$ is limited by the resistive circuit 122.

When a ground fault occurs, the voltage potential towards ground of the phase conductors A, B, C changes and a zero sequence voltage Vo for the phase conductors A, B, C can be observed between the radial node 140 and the ground.

The method 1 comprises some steps in which data related to measured physical quantities are acquired and processed.

For the sake of clarity, in the following, when a physical quantity is referred to as being "measured", it has to be intended that the waveform of said physical quantity was measured, in other words that the modulus and the phase of said physical quantity were measured.

The method 1 comprises the step a) of acquiring first data 101 indicative of the phase currents $I_A$, $I_B$, $I_C$ circulating along the phase conductors A, B, C, advantageously after the occurrence of the ground fault.

The first data 101 are preferably measured values that can be detected by means of properly arranged current sensing means (also of known type), for example current sensors 53 arranged on board an electronic protection and control unit 50.

In an alternative embodiment of the present invention, the first data 101 can be obtained by measuring the active power transmitted along the phase conductors A, B, C by means of properly arranged electric power sensing means (also of known type).

In this case, the step a) of acquiring the data 101 may comprise the step a.1) of acquiring seventh data 107 indicative of the active power transmitted along the phase conductors A, B, C and the step a.2) of calculating the first data 101 on the base of said data 107.

The method 1 comprises the step b) of acquiring second data 102 indicative of the phase voltages $V_A$, $V_B$, $V_C$ of the phase conductors A, B, C.

The second data 102 may be measured values that can be detected by means of properly arranged first voltage sensing means (also of known type), for example voltage sensors 55 arranged on board an electronic protection and control unit 50.

In a preferred embodiment of the present invention, the data 102 are stored data indicative of the phase voltages $V_A$, $V_B$, $V_C$ of the phase conductors A, B, C measured before the occurrence of the ground fault.

When a ground fault occurs, the phase voltages $V_A$, $V_B$, $V_C$ may become quite low, thereby making it difficult to determine the position of the vectors representing said phase voltages with respect to the vectors representing the phase currents $I_A$, $I_B$, $I_C$, in a vector representation of the physical quantities of the network 10.

The use of stored data related to the phase voltages $V_A$, $V_B$, $V_C$ before the occurrence of the ground fault thus enables to reduce the computational load and increase computational accuracy.

The method 1 comprises the step c) of acquiring third data 103 indicative of the zero sequence voltage $V_0$ of the phase conductors A, B, C.

Also the data 103 may be measured values that can be detected by means of properly arranged second voltage sensing means (also of known type), for example a voltage sensor (not shown) arranged at the ground connection circuit 12.

As an alternative, the data 103 may be obtained by processing the data 102, since the zero sequence voltage $V_0$ of the phase conductors A, B, C may be calculated on the base of the phase voltages $V_A$, $V_B$, $V_C$.

The method 1 comprises the step d) of calculating fourth data 104 indicative of the resistive components $I_{RA}$, $I_{RB}$, $I_{RC}$ of the phase currents $I_A$, $I_B$, $I_C$, advantageously on the base of the acquired data 101, 102.

Each of the measured phase currents $I_A$, $I_B$, $I_C$ comprise a resistive component and a reactive component.

In a vector representation of the physical quantities of the network 10, the vectors representing the phase currents $I_A$, $I_B$, $I_C$ can be expressed according to the following relations:

$$I_A = I_{RA} + jI_{XA}$$

$$I_B = I_{RB} + jI_{XB}$$

$$I_C = I_{RC} + jI_{XC}$$

where $I_{RA}$, $I_{RB}$, $I_{RC}$, $I_{XA}$, $I_{XB}$, $I_{XC}$ are respectively the resistive and reactive components of the phase currents $I_A$, $I_B$, $I_C$.

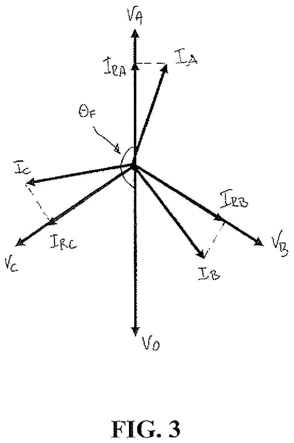

Preferably, the data 104 are advantageously calculated by resolving the phase currents $I_A$, $I_B$, $I_C$ with respect to the corresponding phase voltages $V_A$, $V_B$, $V_C$ (figure 3).

The method 1 comprises the step e) of calculating fifth data 105 indicative of the resistive component $I_{FR}$ of the zero sequence current $I_F$, on the base of the data 104.

Each of the resistive components $I_{RA}$, $I_{RB}$, $I_{RC}$ of the phase currents $I_A$, $I_B$, $I_C$ can be considered as the sum of a resistive current due to the flow of the zero sequence current $I_F$ through the phase conductors and of a resistive current due to the presence of electric loads connected to the network 10.

Similarly, each of the reactive components $I_{XA}$, $I_{XB}$, $I_{XC}$ of the phase currents $I_A$, $I_B$, $I_C$ can be considered as the sum of a reactive current due to the flow of the zero sequence current $I_F$ through the phase conductors and of a reactive current due to the presence of electric loads connected to the network 10.

In a vector representation of the physical quantities of the network 10, the vectors representing the phase currents $I_A$, $I_B$, $I_C$ can thus be expressed according to the following relations:

$$I_A = I_{RA} + jI_{XA} = (I_{FRA} + I_{LRA}) + j(I_{FXA} + I_{LXA})$$

$$I_B = I_{RB} + jI_{XB} = (I_{FRB} + I_{LRB}) + j(I_{FXB} + I_{LXB})$$

$$I_C = I_{RC} + jI_{XC} = (I_{FRC} + I_{LRC}) + j(I_{FXC} + I_{LXC})$$

where $I_{FRA}$, $I_{FRB}$, $I_{FRC}$, $I_{FXA}$, $I_{FXB}$, $I_{FXC}$ are respectively the resistive and reactive currents circulating along the phase conductors A, B, C due to the flow of the zero sequence current $I_F$ and $I_{LRA}$, $I_{LRB}$, $I_{LRC}$, $I_{LXA}$, $I_{LXB}$, $I_{LXC}$ are respectively the resistive and reactive currents circulating along the phase conductors A, B, C due to the presence of the electric loads.

The resistive components $I_{RA}$, $I_{RB}$, $I_{RC}$ of the phase currents $I_A$, $I_B$, $I_C$ are thus given by the following relations:

$$I_{RA} = I_{FRA} + I_{LRA}$$

$$I_{RB} = I_{FRB} + I_{LRB}$$

$$I_{RC} = I_{FRC} + I_{LRC}$$

Supposing that the ground fault is located at the phase conductor A, the resistive currents $I_{FR}$ and $I_{FR}$ flowing along the phase conductors B, C are equal to zero, since the resistive component $I_{FR}$ of the fault current circulates only along the faulted phase conductor A.

The sum of the resistive components $I_{RA}$, $I_{RB}$, $I_{RC}$ of the phase currents $I_A$, $I_B$, $I_C$ are thus given by the following relation:

$$I_{SUM} = I_{RA} + I_{RB} + I_{RC} = I_{FRA} + (I_{LRA} + I_{LRB} + I_{LRC})$$

Since the loads on an electric power distribution network are generally balanced, it can be supposed that $I_{LRA}$ + $I_{LRB}$ + $I_{LRC}$ = 0 for the network 10.

From the above, the following relation is obtained:

$$I_{SUM} = I_{FRA} = I_{FR}.$$

The fifth data 105 can thus be advantageously calculated by calculating the (vector) sum of the resistive components $I_{RA}$, $I_{RB}$, $I_{RC}$ of the phase currents $I_A$, $I_B$, $I_C$.

The method 1 then comprises the step f) of calculating sixth data 106 indicative of the direction of the resistive component $I_{FR}$ of the zero sequence current $I_F$, on the base of the acquired data 103 and the calculated data 105.

In a vector representation of the physical quantities of the network 10, the actual direction of the current vector $I_{FR}$ is preferably determined referring to the zero sequence voltage Vo.

The data 106 are thus calculated by calculating the phase shift $\theta_F$ between the resistive component $I_{FR}$ of the zero sequence current $I_F$ and the zero sequence voltage $V_0$ (figure 3).

The detection method 1 can be advantageously executed in a method for locating a ground fault in a medium or low voltage electric power distribution network.

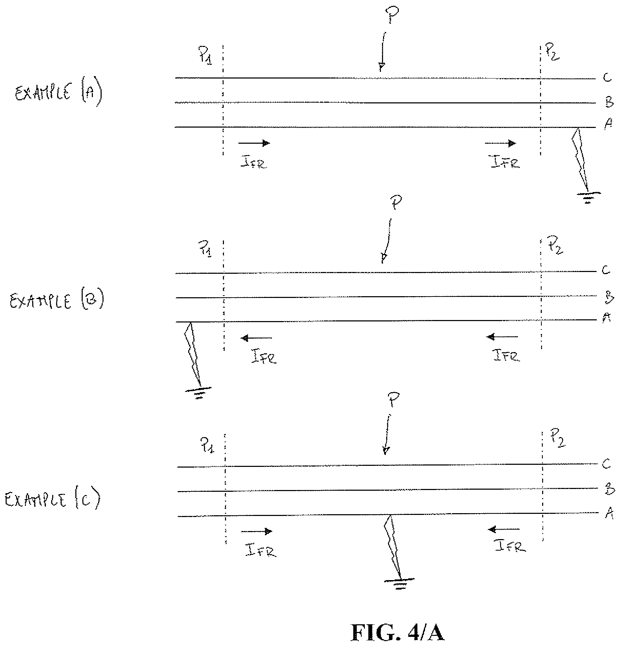

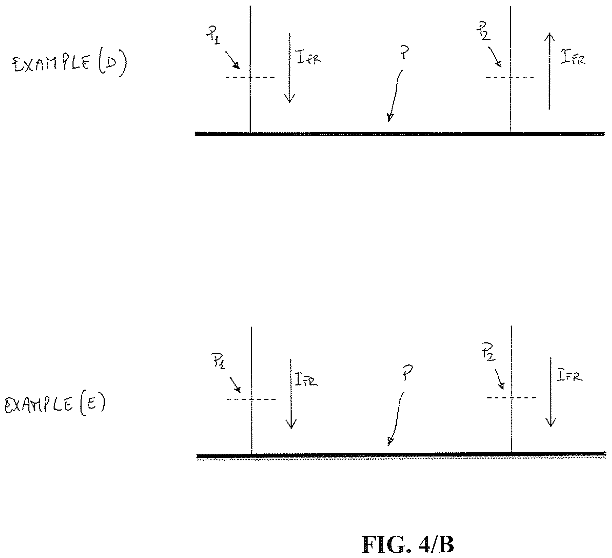

The detection method 1, in fact, provides an output quantity (the direction of the resistive component $I_{SUM}$ = $I_{FR}$ of the zero sequence current $I_F$) that unambiguously enables to determine whether the ground fault is located in a given portion P of the network 10 (figure 4).

Preferably, a method for locating a ground fault in a given portion P of the network 10, which is comprised between two given observation points $P_1$, $P_2$ at its ends, comprises the following steps:

- calculating a first set of sixth data 106 indicative of the direction of the resistive component $I_{FR}$ of the zero sequence current $I_F$ at the first observation point $P_1$ by executing the detection method 1;
- calculating a second set of sixth data 106 indicative of the direction of the resistive component $I_{FR}$ of the zero sequence current $I_F$ at the second observation point $P_2$ by executing the detection method 1;
- determining whether the ground fault is located in the portion P on the base of the calculated first and second sets of data 106.

When the observed portion P of the network 10 is a generic feeder of the network 10, the observation points

$P_1$, $P_2$ may be conveniently positioned at the ends of said feeder.

The following criteria can be adopted to determine whether the ground fault is located at the observed feeder P:

- if the direction of the resistive component $I_{FR}$ of the zero sequence current $I_F$ at the observation point $P_1$ and at the observation point $P_2$ is the same, the ground fault is not located in the feeder P but it is located downstream or upstream with respect to this latter, depending on the direction of the resistive component $I_{FR}$ (examples (A), (B) of figure 4A);
- if the direction of the resistive component $I_{FR}$ of the zero sequence current $I_F$ at the observation point $P_1$ is opposite with respect to the direction at the observation point $P_2$, the ground fault is located in the feeder P (example (C) of figure 4A).

When the observed portion P of the network 10 is a generic bus bar of the network 10, the observation points $P_1$, $P_2$ may be conveniently positioned at the network branches that derive electric power from said bus bar, close to the ends of this latter.

The following criteria can be adopted to determine whether the ground fault is located at the observed busbar P:

- if the direction of the resistive component $I_{FR}$ of the zero sequence current $I_F$ at the observation point $P_1$ is opposite with respect to the direction at the observation point $P_2$, the ground fault is not located in the bus bar P (example (D) of figure 4B). The ground fault may be located in bus bars located downstream or upstream with respect to the bus bar P, depending on the direction of the resistive component $I_{FR}$ at the network branches deriving current from these latter;
- if the direction of the resistive component $I_{FR}$ of the zero sequence current $I_F$ at the observation point $P_1$ and at the observation point $P_2$ is a same direction oriented towards the busbar P, the ground fault is located in the bus bar P (example (E) of figure 4B);

In a further aspect, the present invention relates to an electronic protection and control (P&C) unit 50 that is capable of implementing the detection method 1.

The P&C unit 50 comprises a processing unit 51 (e.g. a microprocessor) that is capable of executing first software instructions 52 for executing the detection method 1.

The software instructions 52 are preferably stored in a memory of the processing unit 51. Alternatively, they can be uploaded from a remote memory location by the processing unit 51 during the operation of the P&C unit.

The P&C unit 50 is preferably provided with a communication port 54 that can be used by the processing unit 51 to communicate with other P&C devices or other external devices through a communication bus 500 (e.g. an ethernet bus) or other communication links.

Preferably, the P&C unit 50 comprises an over-current protection arrangement 570 that is adapted to check whether given currents (e.g. the phase currents $I_A$, $I_B$, $I_C$ or the resistive component $I_{FR}$ of the zero sequence current $I_F$) exceed predefined thresholds and to generate intervention command signals COM when said threshold are exceeded.

Preferably, such an over-current protection arrangement 570 comprises two over-current protections.

A first over-current protection 570A checks whether a given current overcomes a first threshold when it flows along a first direction $D_1$. In this case, the over-current protection 570A generates an intervention command signal COM, preferably with a first time delay $t_1$.

A second over-current protection 570B checks whether a given current overcomes a second threshold when it flows along a second direction $D_2$, opposite to $D_1$. In this case, the over-current protection 570B generates an intervention command signal COM, preferably with a second time delay $t_2$ different from $t_1$.

Preferably, the over-current protections 570A, 570B generate the intervention command signals COM, if they have not received (e.g. during the time intervals $t_1$, $t_2$) inter-block signals $IB_{IN}$ from other P&C units.

Preferably, the over-current protections 570A, 570B are capable of generating inter-block signals $IB_{OUT}$ for other P&C units (e.g. during the time intervals $t_1$, $t_2$).

The inter-block signals $IB_{IN}$, $IB_{OUT}$ are preferably signals of logic type and they may be implemented, for example, by GOOSE data packets transmitted through the communication bus 500.

As an example, an inter-block signal IB having a high/low logic level (IB=1/0) blocks/does not block the intervention of the P&C unit (i.e. the intervention of over-current protection) to which it is delivered.

Preferably, the over-current protection arrangement 570 is software implemented by the processing unit 51. In this case, the processing unit is capable of executing second software instructions 57 to implement the described over-current protection functionalities.

As an alternative, the over-current protection arrangement 570 (or each of the over-current protections 570A, 570B thereof) may be an electronic device that is integrated with the P&C unit and communicate with the processing unit 57.

Preferably, the P&C unit 50 comprises current sensors 53 (e.g. TA transformers, Hall sensors or Rogowski coils) to detect the phase currents $I_A$, $I_B$, $I_C$ flowing along the phase conductors A, B, C.

As an alternative, the P&C unit 50 may comprise on board electric power sensors (not shown) to detect the active power transmitted along the phase conductors A, B, C.

Preferably, the P&C unit 50 comprises voltage sensors 55 (e.g. TV transformers) to detect the phase voltages $V_A$, $V_B$, $V_C$ flowing along the phase conductors A, B, C of the network 10.

Current sensors 53 and voltage sensors 54 are in communication with the processing unit 51 (e.g. through an internal bus), which can thus directly acquire the mentioned data 101, 102 from said sensors.

However, the P&C unit 50 may acquire any data (e.g. the data 101, 102, 103) related to the physical quantities of the network 10 from sensors properly arranged externally to the P&C unit 50, through the communication bus 500 or other communication link.

As mentioned above, the processing unit 51 is capable of executing the software instructions 52 for executing the detection method 1.

In particular, the processing unit 51 is capable of executing the software instructions 52 for:

- acquiring the data 101 indicative of the phase currents $I_A$, $I_B$, $I_C$;
- acquiring the data 102 indicative of the phase voltages $V_A$, $V_B$, $V_C$;
- acquiring the data 103 indicative of the zero sequence voltage Vo;
- calculating the data 104 indicative of the resistive components $I_{RA}$, $I_{RB}$, $I_{RC}$ of the phase currents $I_A$, $I_B$, $I_C$, advantageously on the base of the data 101, 102;
- calculating the data 105 indicative of the resistive component $I_{FR}$ of the zero sequence current $I_F$, on the base of the data 104;
- calculating the data 106 indicative of the direction of the resistive component $I_{FR}$ of the zero sequence current $I_F$, on the base of the data 103, 105.

Preferably, the processing unit 51 is capable of executing the software instructions 52 for acquiring the data 107 indicative of the active power transmitted along the phase conductors A, B, C and for calculating the data 101.

Preferably, the data 102 are stored data indicative of the phase voltages $V_A$, $V_B$, $V_C$, which have been acquired and stored by the processing unit 51 before the occurrence of the ground fault.

Preferably, the processing unit 51 calculates the data 104 by resolving the phase currents $I_A$, $I_B$, $I_C$ with respect the phase voltages $V_A$, $V_B$, $V_C$ of the corresponding phase conductors A, B, C.

The processing unit 51 calculates the data 106 by calculating the phase shift $\theta_F$ between the resistive component $I_{FR}$ of the zero sequence current $I_F$ and the zero sequence voltage $V_0$.

The P&C unit 50 can be autonomously used or easily integrated on board any commonly used protection or switching devices, even if pre-existing and not specifically pre-arranged therefore.

In a further aspect, the present invention relates a protection and control (P&C) system 100 for an electric power distribution network, which comprises one or more P&C units 50.

Preferably, the P&C system 100 comprises a plurality of P&C units 50 that may be arranged according to the needs.

Each couple of P&C units 50 defines in practice a portion of the network 10 to be observed. In the example shown in figure 1, the P&C units 50 advantageously positioned at the ends of the feeders 11A, 11B, 11C, 11D of the network 10.

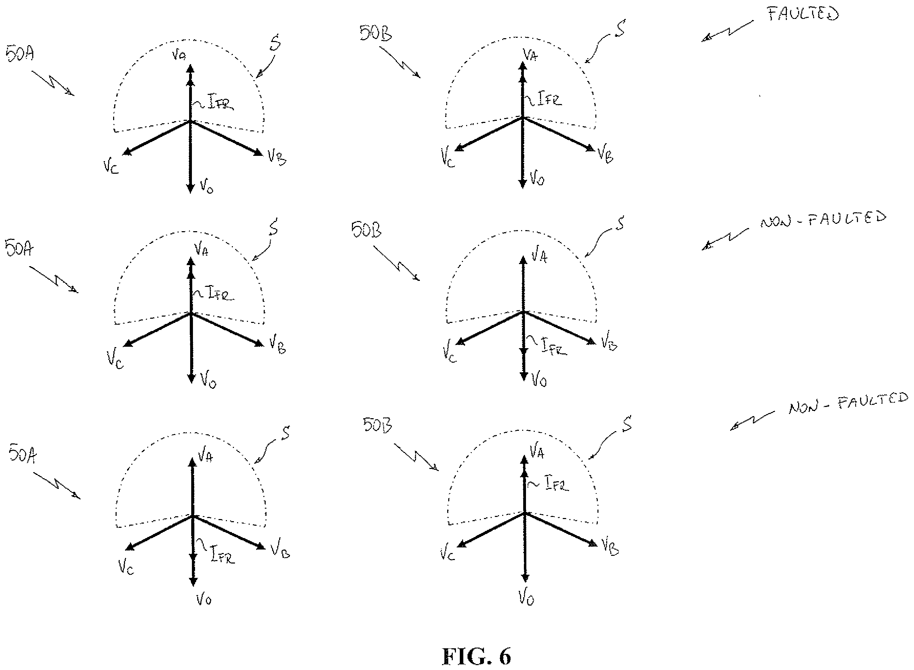

The operation of two P&C units 50A, 50B positioned at the ends of a generic feeder 11 of the network 10 is illustrated in figures 6-7.

The P&C units 50A, 50B are arranged so that the over-current protections 570A, 570B of the protection unit 50A have time delays of $t_1$=100ms and $t_2$=200ms, respectively, while the over-current protections 570A, 570B of the protection unit 50B have time delays of $t_1$=200ms and $t_2$=100ms, respectively.

The P&C units 50A, 50B are advised that a fault occurred somewhere in the network 10 when they receive input data indicating that the zero sequence voltage $V_0$ is different than zero or when they receive warning messages (e.g. warning GOOSE data packets) from other devices (e.g. from other P&C units).

In this case, the processing unit 51 of the P&C units 50A, 50B execute the software instructions 52 to calculate the resistive component $I_{FR}$ of the zero sequence current $I_F$ and its direction thereof.

Once the direction of the resistive component $I_{FR}$ is determined, the operation of the P&C units 50A, 50B is then preferably managed according to a selectivity logic of the chrono-amperometric type, which substantially follows the following criteria (figure 6):

- if the resistive component $I_{FR}$ is directed so as to be within the intervention sector S of both the P&C units 50A, 50B, the ground fault is located in the feeder 11 and the P&C units intervene to cause the electric isolation of the feeder 11 from the network 10;

- if the resistive component $I_{FR}$ is directed so as to be outside the intervention sector S of at least one the P&C units 50A, 50B, the ground fault is located downstream or upstream the feeder 11 and the P&C units do not intervene to cause the electric isolation of the feeder 11.

Said selectivity logic may be implemented in practice by the over-current protections 570A, 570B of each over-current arrangement 570 of the P&C units 50A, 50B according to the following procedure, taken as an example.

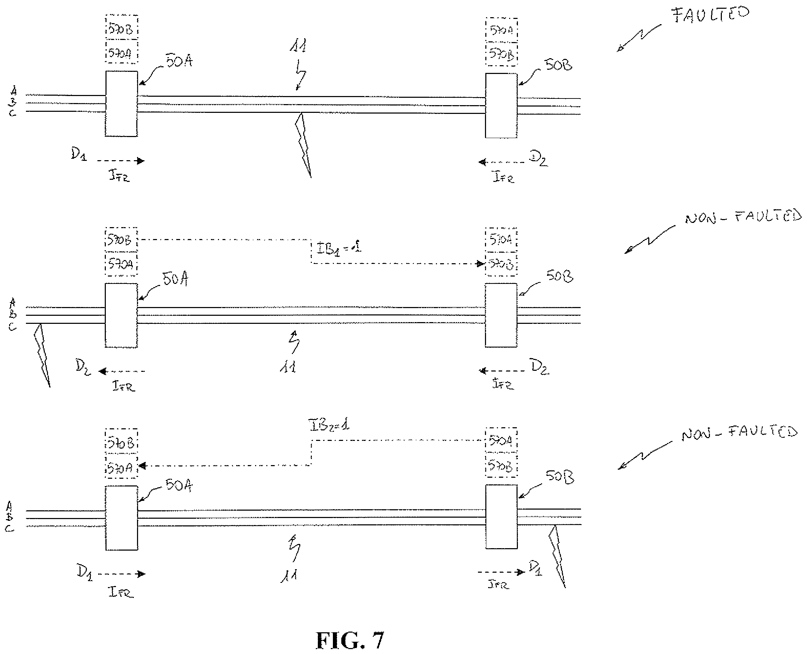

Referring to figure 7, if the P&C unit 50A determines that the resistive component $I_{FR}$ of the zero sequence current $I_F$ is directed according to the direction $D_1$ and the P&C unit 50B determines that the resistive component $I_{FR}$ of the zero sequence current $I_F$ is directed according to the direction $D_2$, opposite to $D_1$, the ground fault is located in the feeder 11.

The over-current protections 570A, 570B of the P&C units 50A, 50B do not generate inter-block signals having a high logic level and both the P&C units 50A, 50B generate command signals COM (e.g. towards properly arranged switching devices) to cause the electric isolation of the feeder 11.

If both the P&C units 50A, 50B determine that the resistive component $I_{FR}$ of the zero sequence current $I_F$ is directed according to the direction $D_2$, the ground fault is located downstream the P&C unit 50A (taking the direction $D_2$ as a reference).

The over-current protection 570B of the P&C unit 50A sends an inter-block signal having a high logic level ($IB_1=1$) to the corresponding over-current protection 570B of the P&C unit 50B, which is positioned upstream with respect to the P&C unit 50A. The P&C unit 50B does not intervene while the P&C unit 50A possibly intervenes after the longest time delay of 200ms has passed.

It is noted that the possible intervention of the P&C unit 50A would only cause the electric isolation of the branches of the network 10 that are positioned downstream it.

If both the P&C units 50A, 50B determine that the resistive component $I_{FR}$ of the zero sequence current $I_F$ is directed according to the direction $D_1$, the ground fault is located downstream the P&C unit 50B (taking the direction $D_1$ as a reference).

The over-current protection 570A of the P&C unit 50B sends an inter-block signal having a high logic level ($IB_2=1$) to the corresponding over-current protection 570A of the P&C unit 50A, which is positioned upstream with respect to the P&C unit 50B. The P&C unit 50A does not intervene while the P&C unit 50B possibly intervenes after the longest time delay of 200ms has passed.

Also in this case, it is noted that the possible intervention of the P&C unit 50B would cause the electric isolation of the branches of the network 10 that are positioned downstream it. Alternative procedures to implement the selectivity logic described above may be implemented, depending on the actual positioning of the P&C units 50A, 50B.

When the observed portion of the network is a bus bar 110, the P&C units 50A, 50B are preferably positioned at the branches 110A, 110B deriving electric power from the bus bar 110 and close to the ends of this latter.

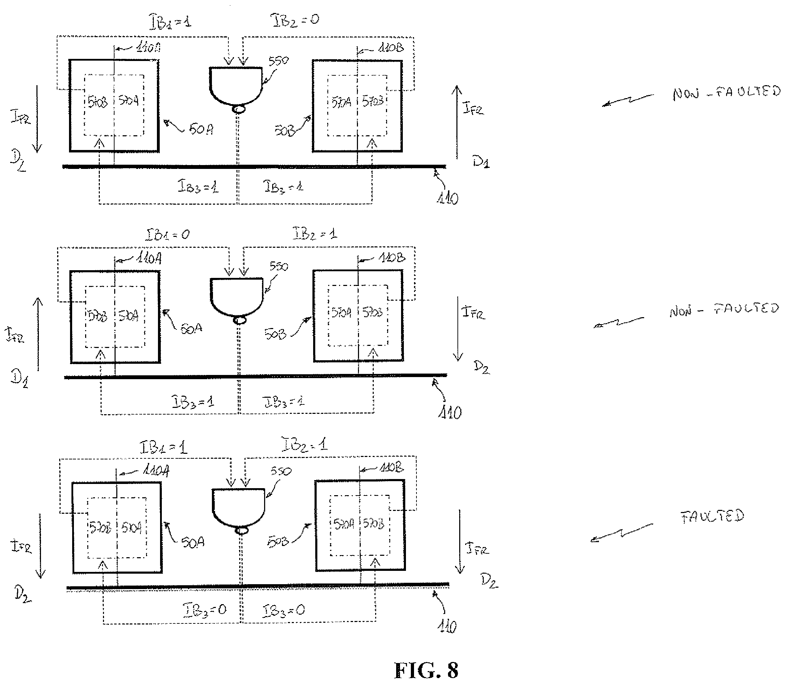

The operation of two P&C units 50A, 50B positioned at branches close to the ends of a generic bus bar 110 of the network 10 is illustrated in figure 8.

The P&C units 50A, 50B are arranged so that the over-current protections 570A, 570B of both the protection units 50A, 50B have time delays of $t_1=100ms$ and $t_2=200ms$, respectively.

The P&C units 50A, 50B are advised that a fault occurred somewhere in the network 10 when they receive input data indicating that the zero sequence voltage $V_0$ is different than zero or when they receive warning messages (e.g. GOOSE messages) from other devices (e.g. from other P&C units).

In this case, the processing unit 51 of the P&C units 50A, 50B execute the software instructions 52 to calculate the resistive component $I_{FR}$ of the zero sequence current $I_F$ and its direction thereof.

Once the direction of the resistive component $I_{FR}$ is determined, the operation of the P&C units 50A, 50B is then preferably managed according to a selectivity logic that is substantially similar to the one described above.

Given the positioning of the P&C units 50A, 50B on the branches 110A, 110B, said selectivity logic may implemented in practice by the over-current protections 570A, 570B of each over-current arrangement 570 of the P&C units 50A, 50B and by a logic block 550 of the NAND type according to the following procedure, taken as an example.

Referring to figure 8, if the P&C unit 50A determines that the resistive component $I_{FR}$ of the zero sequence current $I_F$ is directed according to the direction $D_2$ and the P&C unit 50B determines that the resistive component $I_{FR}$ of the zero sequence current $I_F$ is directed according to the direction $D_1$, opposite to $D_2$, the ground fault is not located in the bus bar 110.

The over-current protection 570B of the P&C unit 50A generates an inter-block signal having a high logic level ($IB_1=1$) while the over-current protection 570B of the P&C unit 50B generates an inter-block signal having a low logic level ($IB_2=0$). The inter-block signals $IB_1$, $IB_2$, generated by the over-current protections 570B of the P&C units 50A, 50B, are received by the logic block 550, which generates a third inter-block signal having a high logic level ($IB_3=1$), according to a NAND logic. The inter-block signal $IB_3$ is sent to the over-current protections 570B of both the P&C units 50A, 50B that will not intervene.

If the P&C unit 50A determines that the resistive component $I_{FR}$ of the zero sequence current $I_F$ is directed according to the direction $D_1$ and the P&C unit 50B determines that the resistive component $I_{FR}$ of the zero sequence current $I_F$ is directed according to the direction $D_2$, opposite to $D_1$, the ground fault is not located in the bus bar 110.

The over-current protection 570B of the P&C unit 50A generates an inter-block signal having a low logic level ($IB_1$=0) while the over-current protection 570B of the P&C unit 50B generates an inter-block signal having a high logic level ($IB_2$=1). The inter-block signals $IB_1$, $IB_2$ are received by the logic block 550, which again generates an inter-block signal having a high logic level ($IB_3$=1), according to a NAND logic. The inter-block signal $IB_3$ is received by the over-current protections 570B of both the P&C units 50A, 50B that will not intervene.

If both the P&C units 50A, 50B determine that the resistive component $I_{FR}$ of the zero sequence current $I_F$ is directed according to a same direction $D_2$, both the over-current protections 570B of the P&C units 50A, 50B generate inter-block signals having a high logic level ($IB_1$=1, $IB_2$=1). The inter-block signals $IB_1$, $IB_2$ are received by the logic block 550, which generates a logic signal having a low logic level ($IB_3$=0), according to a NAND logic. The inter-block signal $IB_3$ is received by the over-current protections 570B of both the P&C units 50A, 50B that will generate command signals COM (e.g. towards properly arranged switching devices) to cause the electric isolation of the bus bar 110.

As, it is apparent from the above the selectivity logic is conveniently implemented by the over-current protections 570B of both the P&C units 50A, 50B, which are set with the longest time delay ($t_2$=200ms).

This arrangement is aimed at avoiding interventions to electrically isolate the bus bar 100, if this is possible.

The same procedure may be applied for managing the operation of the over-current protections 570A of the P&C units 50A, 50B, depending on the direction of the resistive component $I_{FR}$ of the zero sequence current $I_F$ and the time delay that is set for them.

Alternative procedures to implement the selectivity logic described above may be implemented, depending on the actual positioning of the P&C units 50A, 50B.

It has been noted in practice that the present invention enables to achieve the purposes mentioned above.

The detection method, according to the invention, provides a discriminating parameter that unequivocally characterises any portion of an electrically power distribution network affected by a ground fault.

The detection method, according to the invention, therefore enables to perform an easy and reliable locating of a ground fault.

The detection method, according to the invention, enables to implement relatively easy selectivity logics to manage the operation of an electric power distribution network, such as, for example, selectivity logics of the chrono-amperometric type, energy type or temporal type.

The detection method, according to the invention, enables to obtain relatively high levels of tripping selectivity even in electric power distribution networks of the meshed type, with relatively short and optimized tripping times according to the extent and nature of the fault detected.

The detection method, according to the invention, is simple to realize practically and it can be easily software implemented by a processing unit, at relatively contained costs.

Software instructions to implement the detection method, according to the invention, can be easily uploaded by a processing unit, even in pre-existing P&C units not specifically pre-arranged therefore.

This obviously enables to reduce the costs for adapting an already existing protection and control system to a configuration change (e.g. from radial to meshed configuration) of the electric power distribution network, which may, for example, be due to the setting of distributed power generation sources.

## Claims

1. A detection method (1) of a ground fault in an electric power distribution network (10) comprising the following steps:

   a) acquiring first data (101) indicative of phase currents ($I_A$, $I_B$, $I_C$) circulating along one or more phase conductors (A, B, C) of said electric power distribution network;
   b) acquiring second data (102) indicative of one or more phase voltages ($V_A$, $V_B$, $V_C$) of said phase conductors;
   c) acquiring third data (103) indicative of a zero sequence voltage ($V_0$) of said phase conductors;
   d) calculating fourth data (104) indicative of resistive components ($I_{RA}$, $I_{RB}$, $I_{RC}$) of said phase currents ($I_A$, $I_B$, $I_C$);

   **characterised in that** it comprises the following steps:

   e) calculating fifth data (105) indicative of a resistive component ($I_{FR}$) of a zero sequence current ($I_F$), which circulates along said electric power distribution network, said fifth data being calculated on the base of said fourth data indicative of the resistive components ($I_{RA}$, $I_{RB}$, $I_{RC}$) of said phase currents ($I_A$, $I_B$, $I_C$);

f) calculating sixth data (106) indicative of the direction of the resistive component ($I_{FR}$) of said zero sequence current ($I_F$), said sixth data (106) being calculated by calculating the phase shift ($\theta_F$) between the resistive component ($I_{FR}$) of said zero sequence current ($I_F$) and said zero sequence voltage (Vo).

2. A detection method, according to claim 1, **characterised in that** said step of acquiring said first data (101) comprises the step a.1) of acquiring seventh data (107) of active power transmitted along said phase conductors (A, B, C) and the step a.2) of calculating said first data (101) on the base of said seventh data.

3. A detection method, according to one or more of the previous claims, **characterised in that** said second data (102) are stored data indicative of the phase voltages ($V_A$, $V_B$, $V_C$) of said phase conductors (A, B, C) before the occurrence of said ground fault.

4. A detection method, according to one or more of the previous claims, **characterised in that** said third data (103) are calculated on the base of said second data (102).

5. A detection method, according to one or more of the previous claims, **characterised in that** said fourth data (104) are calculated by resolving said phase currents ($I_A$, $I_B$, $I_C$) with respect the phase voltages ($V_A$, $V_B$, $V_C$) of the corresponding phase conductors (A, B, C).

6. A detection method, according to one or more of the previous claims, **characterised in that** said electric power distribution network (10) is of the meshed type and/or with a distributed power generation.

7. A detection method, according to claims 6, **characterised in that** said electric power distribution network (10) is provided with a compensated neutral.

8. A method for locating a ground fault in an electric power distribution network (10), **characterised in that** it comprises a step of executing a detection method, according to one or more of the previous claims.

9. A method, according to claim 8, **characterised in that** it comprises the following steps:

   - calculating a first set of sixth data (106) indicative of the direction of a resistive component ($I_{FR}$) of a zero sequence current ($I_F$) at a first observation point ($P_1$) of said electric power distribution network (10) by executing a detection method, according to one or more of the claims from 1 to 8;
   - calculating a second set of sixth data (106) indicative of the direction of said resistive component ($I_{FR}$), at a second observation point ($P_2$) of said electric power distribution network (10) by executing a detection method, according to one or more of the previous claims from 1 to 8;
   - determining whether a ground fault is located in a portion (P) of said electric power distribution network (10), which is comprised between said first and second check point ($P_1$, $P_2$), on the base of said first and second set of sixth data (106).

10. An electronic protection and control unit (50) for an electric power distribution network (10), **characterized in that** it comprises a processing unit (51) adapted to execute first software instructions (52) for executing a detection method, according to one or more of the claims from 1 to 7.

11. A protection and control system for an electric power distribution network (10) **characterised in that** it comprises one or more electronic protection and control units (50), according to claim 10.

**Patentansprüche**

1. Detektionsverfahren (1) eines Erdschlusses in einem elektrischen Energieverteilungsnetz (10), umfassend die folgenden Schritte:

   a) Erfassen erster Daten (101), die die Phasenströme ($I_A$, $I_B$, $I_C$) anzeigen, die entlang eines oder mehrerer Phasenleiter (A, B, C) des elektrischen Energieverteilungsnetzes zirkulieren;
   b) Erfassen von zweiten Daten (102), die eine oder mehrere Phasenspannungen ($V_A$, $V_B$, $V_C$) der Phasenleiter anzeigen;
   c) Erfassen von dritten Daten (103), die eine Nullsequenzspannung (Vo) der Phasenleiter anzeigen;

d) Berechnen von vierten Daten (104), die die Widerstandskomponenten ($I_{RA}$, $I_{RB}$, $I_{RC}$) der Phasenströme ($I_A$, $I_B$, $I_C$) anzeigen;

**dadurch gekennzeichnet, dass** es die folgenden Schritte umfasst:

e) Berechnen von fünften Daten (105), die eine Widerstandskomponente ($I_{FR}$) eines Nullsequenzstroms ($I_F$) anzeigen, der entlang des elektrischen Energieverteilungsnetzes zirkuliert, wobei die fünften Daten auf der Grundlage der vierten Daten berechnet werden, die die Widerstandskomponenten ($I_{RA}$, $I_{RB}$, $I_{RC}$) der Phasenströme ($I_A$, $I_B$, Ic) anzeigen;

f) Berechnen von sechsten Daten (106), die die Richtung der Widerstandskomponente ($I_{FR}$) des Nullsequenzstroms ($I_F$) anzeigen, wobei die sechsten Daten (106) durch Berechnen der Phasenverschiebung ($\theta_F$) zwischen der Widerstandskomponente ($I_{FR}$) des Nullsequenzstroms ($I_F$) und der Nullsequenzspannung ($V_0$) berechnet werden.

2. Detektionsverfahren nach Anspruch 1, **dadurch gekennzeichnet, dass** der Schritt des Erfassens der ersten Daten (101) den Schritt a.1) des Erfassens siebter Daten (107) von Wirkleistung, die entlang der Phasenleiter (A, B, C) übertragen werden, und den Schritt a.2) des Berechnens der ersten Daten (101) auf der Grundlage der siebten Daten umfasst.

3. Detektionsverfahren nach einem oder mehreren der vorhergehenden Ansprüche, **dadurch gekennzeichnet, dass** die zweiten Daten (102) gespeicherte Daten sind, die die Phasenspannungen ($V_A$, $V_B$, $V_C$) der Phasenleiter (A, B, C) vor dem Auftreten des Erdschlusses anzeigen.

4. Detektionsverfahren nach einem oder mehreren der vorhergehenden Ansprüche, **dadurch gekennzeichnet, dass** die dritten Daten (103) auf der Grundlage der zweiten Daten (102) berechnet werden.

5. Detektionsverfahren nach einem oder mehreren der vorhergehenden Ansprüche, **dadurch gekennzeichnet, dass** die vierten Daten (104) durch Auflösen der Phasenströme ($I_A$, $I_B$, $I_C$) in Bezug auf die Phasenspannungen ($V_A$, $V_B$, $V_C$) der entsprechenden Phasenleiter (A, B, C) berechnet werden.

6. Detektionsverfahren nach einem oder mehreren der vorhergehenden Ansprüche, **dadurch gekennzeichnet, dass** das elektrische Energieverteilungsnetz (10) vom Maschentyp und/oder mit einer verteilten Energieerzeugung ist.

7. Detektionsverfahren nach Anspruch 6, **dadurch gekennzeichnet, dass** das elektrische Energieverteilungsnetz (10) mit einem kompensierten Neutralleiter bereitgestellt ist.

8. Verfahren zur Lokalisierung eines Erdschlusses in einem elektrischen Energieverteilungsnetz (10), **dadurch gekennzeichnet, dass** es einen Schritt zur Durchführung eines Detektionsverfahrens nach einem oder mehreren der vorhergehenden Ansprüche umfasst.

9. Verfahren nach Anspruch 8, **dadurch gekennzeichnet, dass** es die folgenden Schritte umfasst:

- Berechnen eines ersten Satzes von sechsten Daten (106), die die Richtung einer Widerstandskomponente ($I_{FR}$) eines Nullsequenzstroms ($I_F$) an einem ersten Beobachtungspunkt ($P_1$) des elektrischen Energieverteilungsnetzes (10) anzeigen, durch Ausführen eines Detektionsverfahrens nach einem oder mehreren der Ansprüche 1 bis 8;
- Berechnen eines zweiten Satzes von sechsten Daten (106), die die Richtung der Widerstandskomponente ($I_{FR}$) an einem zweiten Beobachtungspunkt ($P_2$) des elektrischen Energieverteilungsnetzes (10) anzeigen, durch Ausführen eines Detektionsverfahrens nach einem oder mehreren der vorhergehenden Ansprüche 1 bis 8;
- Bestimmen, ob ein Erdschluss in einem Abschnitt (P) des elektrischen Energieverteilungsnetzes (10) liegt, der zwischen dem ersten und zweiten Prüfpunkt ($P_1$, $P_2$) enthalten ist, auf der Grundlage des ersten und zweiten Satzes von sechsten Daten (106).

10. Elektronische Schutz- und Steuereinheit (50) für ein elektrisches Energieverteilungsnetz (10), **dadurch gekennzeichnet, dass** sie eine Verarbeitungseinheit (51) umfasst, die geeignet ist, erste Softwarebefehle (52) zur Ausführung eines Detektionsverfahrens nach einem oder mehreren der Ansprüche 1 bis 7 auszuführen.

11. Schutz- und Steuersystem für ein elektrisches Energieverteilungsnetz (10), **dadurch gekennzeichnet, dass** es eine oder mehrere elektronische Schutz- und Steuereinheiten (50) nach Anspruch 10 umfasst.

**Revendications**

1. Procédé de détection (1) d'un défaut à la terre dans un réseau de distribution d'énergie électrique (10) comprenant les étapes suivantes :

   a) acquérir des premières données (101) indicatives de courants de phase ($I_A$, $I_B$, $I_C$) circulant le long d'un ou plusieurs conducteurs de phase (A, B, C) dudit réseau de distribution d'énergie électrique ;
   b) acquérir des deuxièmes données (102) indicatives d'une ou plusieurs tensions de phase ($V_A$, $V_B$, $V_C$) desdits conducteurs de phase ;
   c) acquérir des troisièmes données (103) indicatives d'une tension homopolaire (Vo) desdits conducteurs de phase ;
   d) calculer des quatrièmes données (104) indicatives de composantes résistives ($I_{RA}$, $I_{RB}$, $I_{RC}$) desdits courants de phase ($I_A$, $I_B$, $I_C$) ;

   **caractérisé en ce qu'**il comprend les étapes suivantes :

   e) calculer des cinquièmes données (105) indicatives d'une composante résistive ($I_{FR}$) d'un courant homopolaire ($I_F$), qui circule le long dudit réseau de distribution d'énergie électrique, lesdites cinquièmes données étant calculées sur la base desdites quatrièmes données indicatives des composantes résistives ($I_{RA}$, $I_{RB}$, $I_{RC}$) desdits courants de phase ($I_A$, $I_B$, $I_C$) ;
   f) calculer des sixièmes données (106) indicatives de la direction de la composante résistive ($I_{FR}$) dudit courant homopolaire ($I_F$), lesdites sixièmes données (106) étant calculées en calculant le déphasage ($\theta_F$) entre la composante résistive ($I_{FR}$) dudit courant homopolaire ($I_F$) et ladite tension homopolaire (Vo).

2. Procédé de détection, selon la revendication 1, **caractérisé en ce que** ladite étape consistant à acquérir lesdites premières données (101) comprend l'étape a.1) consistant à acquérir des septièmes données (107) de puissance active transmise le long desdits conducteurs de phase (A, B, C) et l'étape a.2) consistant à calculer lesdites premières données (101) sur la base desdites septièmes données.

3. Procédé de détection, selon une ou plusieurs des revendications précédentes, **caractérisé en ce que** lesdites deuxièmes données (102) sont des données stockées indicatives des tensions de phase ($V_A$, $V_B$, $V_C$) desdits conducteurs de phase (A, B, C) avant l'apparition dudit défaut à la terre.

4. Procédé de détection, selon une ou plusieurs des revendications précédentes, **caractérisé en ce que** lesdites troisièmes données (103) sont calculées sur la base desdites deuxièmes données (102).

5. Procédé de détection, selon une ou plusieurs des revendications précédentes, **caractérisé en ce que** lesdites quatrièmes données (104) sont calculées en résolvant lesdits courants de phase ($I_A$, $I_B$, $I_C$) par rapport aux tensions de phase ($V_A$, $V_B$, $V_C$) des conducteurs de phase correspondants (A, B, C).

6. Procédé de détection, selon une ou plusieurs des revendications précédentes, **caractérisé en ce que** ledit réseau de distribution d'énergie électrique (10) est du type maillé et/ou avec une production d'énergie distribuée.

7. Procédé de détection, selon la revendication 6, **caractérisé en ce que** ledit réseau de distribution d'énergie électrique (10) est muni d'un neutre compensé.

8. Procédé de localisation d'un défaut à la terre dans un réseau de distribution d'énergie électrique (10), **caractérisé en ce qu'**il comprend une étape consistant à exécuter un procédé de détection, selon une ou plusieurs des revendications précédentes.

9. Procédé, selon la revendication 8, **caractérisé en ce qu'**il comprend les étapes suivantes :

   - calculer un premier ensemble de sixièmes données (106) indicatives de la direction d'une composante résistive ($I_{FR}$) d'un courant homopolaire ($I_F$) au niveau d'un premier point d'observation ($P_1$) dudit réseau de distribution d'énergie électrique (10) en exécutant un procédé de détection, selon une ou plusieurs des revendications 1 à 8 ;

- calculer un second ensemble de sixièmes données (106) indicatives de la direction de ladite composante résistive ($I_{FR}$), au niveau d'un second point d'observation ($P_2$) dudit réseau de distribution d'énergie électrique (10) en exécutant un procédé de détection, selon une ou plusieurs des revendications précédentes 1 à 8 ;
- déterminer si un défaut à la terre est situé dans une partie (P) dudit réseau de distribution d'énergie électrique (10), qui est comprise entre ledit premier et second point de contrôle ($P_1$, $P_2$), sur la base dudit premier et second ensemble de sixièmes données (106).

10. Unité de protection et de contrôle électronique (50) pour un réseau de distribution d'énergie électrique (10), **caractérisée en ce qu'**elle comprend une unité de traitement (51) adaptée pour exécuter des premières instructions de logiciel (52) pour exécuter un procédé de détection, selon une ou plusieurs des revendications 1 à 7.

11. Système de protection et de contrôle pour un réseau de distribution d'énergie électrique (10) **caractérisé en ce qu'**il comprend une ou plusieurs unités de protection et de contrôle électroniques (50), selon la revendication 10.

FIG. 1

FIG. 2

FIG. 3

FIG. 4/A

EXAMPLE (D)

$P_1$ $I_{FR}$ $P$ $P_2$ $I_{FR}$

EXAMPLE (E)

$P_1$ $I_{FR}$ $P$ $P_2$ $I_{FR}$

**FIG. 4/B**

FIG. 5

FIG. 6

EP 2 752 674 B1

**FIG. 7**

FIG. 8

**EP 2 752 674 B1**

**Patent documents cited in the description**

- WO 2011029464 A1
- US 2008211511 A1
- EP 1331715 A1
- EP 1195875 A2